# EUROPEAN PATENT SPECIFICATION

(11) **EP 1 829 154 B1**
(45) Date of publication and mention of the grant of the patent: **02.09.2009**
(21) Application number: 05850863.1
(22) Date of filing: 13.12.2005
(51) Int. Cl.: H01P 5/19

(54) **LOW-LOSS, ASYMMETRICAL COMBINER FOR PHASE DIFFERENTIAL SYSTEMS AND ADAPTIVE RF AMPLIFIER COMPRISING AN ASYMMETRICAL COMBINER**
ASYMMETRISCHER KOMBINATOR MIT GERINGEM VERLUST FÜR PHASENDIFFERENZSYSTEME UND ADAPTIVER HF-VERSTÄRKER MIT EINEM ASYMMETRISCHEN KOMBINATOR
COMBINATEUR ASYMETRIQUE A FAIBLE PERTE POUR SYSTEMES A DEPHASAGE ET AMPLIFICATEUR RF ADAPTATIF COMPRENANT UN COMBINATEUR ASYMETRIQUE

(30) Priority: 14.12.2004 NL 1027745
(43) Date of publication of application: 05.09.2007
(73) Proprietor: NXP B.V., 5656 AG Eindhoven (NL); O. Bosma Beheersmaatschappij B.V. H.O.D.N. Master, 1671 ED Medemblik (NL)
(72) Inventor: BOSMA, Olaf, NL-5656 AA Eindhoven (NL)
(74) Representative: van der Veer, Johannis Leendert
(86) International application number: PCT/IB2005/054211
(87) International publication number: WO 2006/064466

(56) References cited:
- EP-A- 1 187 314
- EP-A- 1 394 932
- WO-A-03/061115
- JP-A- 59 210 706
- US-A1- 2002 135 425
- GAJADHARSING J R ET AL: "Analysis and design of a 200W LDMOS based doherty amplifier for 3G base stations" MICROWAVE SYMPOSIUM DIGEST, 2004 IEEE MTT-S INTERNATIONAL FORT WORTH, TX, USA JUNE 6-11, 2004, PISCATAWAY, NJ, USA,IEEE, 6 June 2004 (2004-06-06), pages 529-532, XP010727602 ISBN: 0-7803-8331-1
- YANG Y ET AL INSTITUTE OF ELECTRICAL AND ELECTRONICS ENGINEERS: "EXPERIMENTAL INVESTIGATION ON EFFICIENCY AND LINEARITY OF MICROWAVE DOHERTY AMPLIFIER" 2001 IEEE MTT-S INTERNATIONAL MICROWAVE SYMPOSIUM DIGEST.(IMS 2001). PHOENIX, AZ, MAY 20 - 25, 2001, IEEE MTT-S INTERNATIONAL MICROWAVE SYMPOSIUM, NEW YORK, NY : IEEE, US, vol. VOL. 2 OF 3, 20 May 2001 (2001-05-20), pages 1367-1370, XP001067479 ISBN: 0-7803-6538-0
- YOUNGOO YANG ET AL: "A Fully Matched N-Way Doherty Amplifier With Optimized Linearity" IEEE TRANSACTIONS ON MICROWAVE THEORY AND TECHNIQUES, IEEE SERVICE CENTER, PISCATAWAY, NJ, US, vol. 51, no. 3, March 2003 (2003-03), XP011076951 ISSN: 0018-9480

## Description

The invention relates to an amplifier system comprising a combiner.

Third generation telephone systems are based on the Universal Mobile Telecommunications System, UMTS, which uses 5 Megahertz Wideband Code Division Multiple Access. The total bandwidth is 60 MHz and ranges from 2110 MHz to 2170 MHz for base station to mobile traffic. A UMTS network comprises a large number of base station transmitters for transmitting the UMTS radio signal. Each of these base station transmitters comprises linear output amplifiers. Due to the composition of the UMTS signal, said transmitters produce an output signal whose average output power is much less than the maximum output power for which these transmitters are dimensioned. As a result, these transmitters exhibit high power consumption and produce a great deal of heat in relation to the actual output power. In other words: the efficiency of these transmitters is low. This problem can be alleviated by using known adaptive amplifier systems in which the behavior of the amplifier is dependent on the input signal, as is the case with a Doherty system, for example. These known systems, however, require relatively complex designs, which are difficult to produce. In other systems two separate, identical signals with a mutual phase difference are generated. The two signals are each amplified by a separate amplifier, and finally the two signals are "added" together again in a so-termed combiner. If phase differences exist between the two signals that are to be combined, a significant loss of power will occur, however. Conventional combiners provided with an output resistor (load) exhibit advantageous properties as regards the combining of signals. In the case of phase differences between the two signals to be added together, however, this type of combiner will allow a great deal of power to dissipate in the load, resulting in considerable losses. Conventional combiners not provided with an output resistor do not have this drawback, of course, but in the case of phase differences between the two input signals, power reflections generate a reactive component in the input impedance, likewise resulting in considerable losses. This occurs in particular when the output transistors of the amplifiers operate close to their cut-off frequency, which is generally the case with UMTS.

US 2002/013542, as the closest prior art document, describes an output matching amplifier for a Doherty System comprising an input being divided into two signal paths, wherein the first one is guided to a carrier amplifier via a first input matching circuit and the second one is guided to a peaking amplifier via a second input matching circuit. A first load matching circuit is coupled to the carrier amplifier and a second load matching circuit is coupled to the peaking amplifier. A first impedance line having a first angle of θ_{c} and a second impedance line having a second angle of θₚ are positioned behind the first and second load matching circuits, respectively. A quarter wave transformer is positioned behind an impedance line, to cause a Doherty operation. In order to compensate a phase difference between the first path and the second path, an impedance line having an angle of 90°+ θ_{c} - θₚ is inserted in front of an input matching circuit of the peaking amplifier. Both θ_{c} and θₚ are in a 40° - 60° range.

JP 59 210 706 A describes an asymmetric branching and matching type power combining amplifier circuit comprising a first and second microwave line having the same admittance and two input branch lines having different admittance. Corresponding to the line length of the branch lines a phase shifting is present. The input terminals of each element amplifier are not matched, such that a part of the input wave to the input terminal of each amplifier is reflected. The two amplifiers are positioned in the two branch lines in such a manner that the reflected wave from the input reps. output of the amplifiers are canceled each other at the input branch point resp. output branch point.

The object of the invention is to provide a combiner with a high amplifying efficiency and at the same time with a simple design.

The combiner of the present invention avoids these drawbacks and combines two signals with a mutual phase difference without significant losses. This makes it possible to obtain an improved amplifier system having a relatively great band width. At the same time, this amplifier system has this advantage that it can be produced in a relatively simple manner, without the stability problems that are encountered in Doherty-systems.

An advantage of the combiner for phase difference systems is that it is low-loss. This advantage is obtained in part because an output resistor is not needed. The point of outcoupling from the combiner is asymmetrically positioned with respect to the two inputs, such that the combiner has a desired input impedance for input signals with a large range of mutual phase differences. This desired input impedance has a very low reactive component, whilst the real part of the input impedance increases as the phase difference between the input signals increases.

The combiner according to the present invention can be used very advantageously in an adaptive amplifier system. This makes it possible to realize an amplifier system, which, in the case of input signals of varying amplitude, exhibits a high degree of efficiency over a wide amplitude range

Furthermore, an adaptive RF amplifier is disclosed in which the input signal is amplified in an active splitter and split into two or more signals with a mutual phase difference in a manner that is dependent on the amplitude of the input signal. After further amplification, said two or more split signals are combined again by the low-loss combiner. In he case of small signal sizes the amplifier functions as a linear amplifier with enhanced efficiency, in the case of large signal sizes the amplifier functions as a LINC-amplifier (Linear amplification using Non-linear Components). The overall result of these combined processes is a linearly amplifying system with enhanced efficiency over the entire range of signal sizes.

The amplifier system and the combiner according to the invention can be realized by using varying transistor production technologies as known to those skilled in the art. Furthermore it is possible to integrate the combiner and the amplifiers into a monolithic solution. A discrete solution or a system-in-a-package is by no means excluded, however.

The resulting amplifier system is very suitable for amplifying in particular identically RF signals, for example in a mobile phone or in a base station. Although the invention is very suitable for wider bands, such as UMTS band, it can also be used advantageously with other bands, as GSM, CDMA, T-CDMA, W-CDMA, W-LAN, 802.11 and the like.

Although the invention will be explained below on the basis of an amplifier system comprising two amplifiers, it is not excluded that the amplifier system comprises a larger number of amplifiers. Besides pre-amplifiers, it is also possible to connect more amplifiers in parallel. Said amplifiers may be connected to combiners in pairs, for example vie a hierarchy.

The above and further aspects of the combiner and the amplifier system according to the invention will be explained in more detail with reference to the figures, in which:
Fig. 1 schematically shows the combiner in combination with a non-adaptive amplifier system;
Fig. 2 shows a graph in which the relative impedance (Rel die imp) and the relative efficiency (Rel eff) are plotted as a function of the drive angle (angle (degr)):
Fig. 3 schematically shows the combiner in combination with an adaptive amplifier system, and
Fig. 4 schematically shows the operation of the adaptive amplifier system as a function of the signal size.

### Phase difference RF amplifier systems with a low-loss combiner

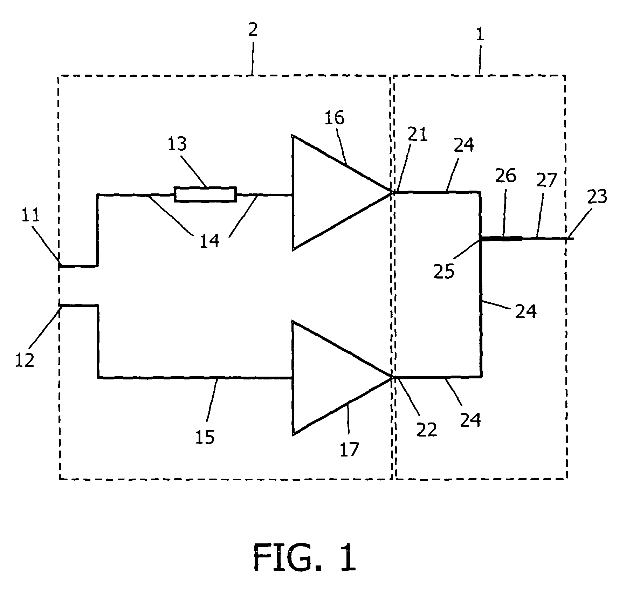

The low-loss combiner is realized in that the outcoupling point is selected to be asymmetrically positioned with respect to the two combiner inputs. The combiner in combination with a non-adaptive amplifier system is schematically shown in Fig. 1. In the figure, numeral 1 indicates the combiner and numeral 2 indicates the non-adaptive amplifier system. The combiner 1 comprises combiner inputs 21 and 22 and a combiner output 23. A signal conductor 24 interconnects the combiner inputs 21 and 22. The signal conductor 24 is of a type that has a specific characteristic impedance. The length of the signal conductor 24 is about a whole multiple of a half wavelength of the RF signals that are to be combined. The outcoupling point 25, where the combined signal is coupled out, is selected to be asymmetrically positioned on the signal conductor 24, at an unequal distance from each of the combiner inputs 21 and 22. Since the signals to be combined must travel an unequal path length between the respective combiner inputs 21 and 22 on the one hand and the outcoupling point 25 on the other hand, a phase shift occurs between the two signals. The outcoupling point 25 is connected to the combiner output 23 via signal conductors 26 and 27. The amplifier system 2 comprises inputs 11 and 12. The input 11 is connected to the input of an amplifier 16 by means of a signal conductor 14 and the input 12 is connected to the input of an amplifier 17 by means of a signal conductor 15. A delay circuit 13 is incorporated in the signal conductor 14. Like the signal conductor 24, the signal conductors 14, 15, 26 and 27 and the delay circuit 13 have a specific characteristic impedance. The combiner 1 combines the output signals of the amplifiers 16 and 17. The outputs of the amplifiers are to that end directly connected to the combiner inputs 21 and 22. The aforesaid desired length of a whole multiple of a half wavelength between the two amplifier outputs needs to be present between the respective output transistors of the amplifiers 16 and 17. In practice, the output of an amplifier will usually comprise an adapter circuit of a certain path length. Corrections need to be made for this by adapting the length of the signal conductor 24, so that the path length between the two output transistors is a whole multiple of a half wavelength. The wavelength is dependent on the frequency of the signals to be combined, so that a combiner functions optimally at a certain design frequency and a frequency range thereabout. The outcoupling point 25 and the delay circuit 13 are selected so that the phase shifts they introduce will be of identical magnitude but of opposite sense, so that said phase shifts will offset each other.

The signal conductors are microstrip lines, for example. In order to ensure a correct operation, the two amplifiers are given the same nominal output impedance, and a value equal to said nominal output impedance is selected for the characteristic input impedance of the microstrip line 24, which impedance also forms the terminal impedance for the amplifiers 16 and 17. The combiner 1 does not comprise an additional output resistor (load). A usual value for the nominal output impedance of the amplifiers is 50Ω, so that the characteristic impedance of the microstrip line must also be 50Ω. In this case the characteristic impedance at the outcoupling point is only 25Ω, however, because two branches of the microstrip line 24, each having a value or 50Ω, are connected in parallel. If an output impedance of 50Ω is required at the output 27, this can be realized by connecting a so-termed transformer to the outcoupling point 25, with the transformer being a microstrip line. 26 having a length of ¼ wavelength and a characteristic impedance of (25 x 50) ½ = 35.3Ω. Subsequently, the free end of the microstrip line 26 is connected to the output 23 by a microstrip line 27 having a characteristic impedance of 50Ω. It will be apparent that it is also possible to select a different output impedance, as long as a transformer is arranged between the two microstrip lines not having the same impedance in the case of impedance transitions, in which case the transformer must have a length of ¼ wavelength and a characteristic impedance that is the root of the product of the two mutually different impedances. If an impedance transition is not required, the transformer 26 can be left out and the microstrip line 27 having a characteristic impedance of 25Ω can form the direct connection between the outcoupling point 25 and the output 23. It will be apparent that other values for the characteristic impedances of the microstrip lines 24, 26 and 27 may be selected in dependence on the output impedances of the amplifiers 16 and 17 and the desired output impedance on the output 23.

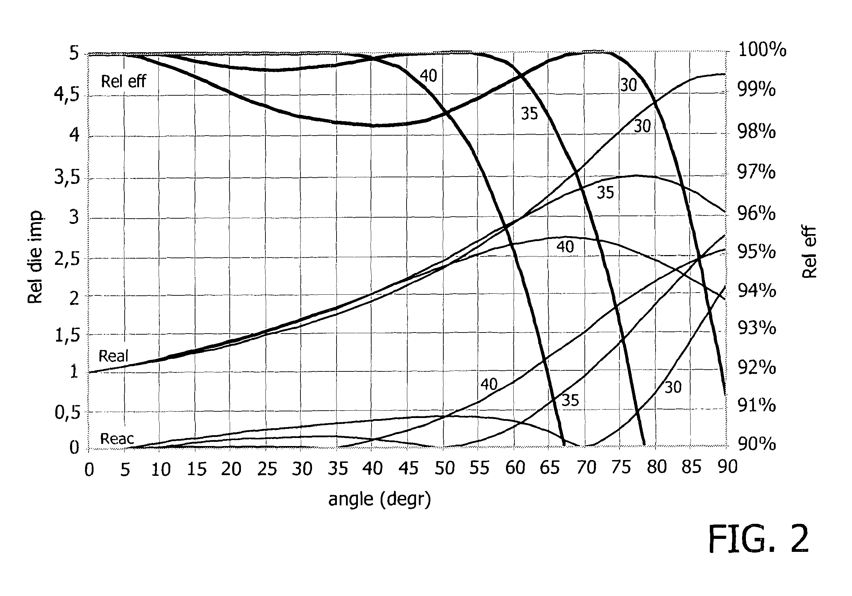

The behavior of a combiner having an asymmetrical outcoupling point has been simulated, and the results of the calculations are shown in Fig. 2. The curves that are shown in Fig. 2 represent the characteristics of the combiner with three different asymmetric selections of the outcoupling point 25, resulting in a phase shift of 30, 35 and 40 degrees, respectively. The phase angle is the difference of phase between the two input signals, in which connection it is noted that the phase angle applies between the input 11 and 12. Furthermore, Real is the real part and Reac is the reactive part of the input impedance of the combiner that is set as the standard. For the standardization, the real part of the input impedance at a phase angle of zero has been set at 1. From the calculations as shown in Fig. 2 it appears that when asymmetry of the outcoupling point 25 is selected so that a phase shift of about 30 - 40 degrees results, a special condition arises: the reactive part of the input impedances, Reac, remains very small over a large range of phase angles, whereas the real part Real of the input impedance increases approximately proportionally with the phase angle. In the case of an asymmetrical outcoupling point resulting in a phase shift of less than 30 degrees, the reactive part of the input impedance exhibits a significant increase with phase angles in the middle of the usable range, which is undesirable. In the case of an asymmetrical outcoupling point resulting in a phase shift of more than 40 degrees, the attainable increase in the impedance decreases as a function of the phase angle, with the increase of the reactive part of the input impedance remaining at an acceptable level, below a factor of 2.5. This is the reason why the system no longer functions at a value a few degrees outside this range, and the asymmetry of the outcoupling point 25 must be selected so that it will result in a phase shift of about 25 to 45 degrees, preferably about 30 to 40 degrees. Fig. 2 furthermore shows that in the case of an asymmetry of the combiner of 30 degrees, the efficiency level Rel eff of the combiner remains above 98% with a phase angle of input signals 11, 12 of up to 80 degrees. In the case of an asymmetry of 35 degrees and 40 degrees, respectively, the efficiency level remains above 99.5% with a phase angle of up to 60 degrees and a value of 99.9% with a phase angle of up to 40 degrees.

### Adaptive phase difference controlled RF amplifier comprising a low-loss combiner.

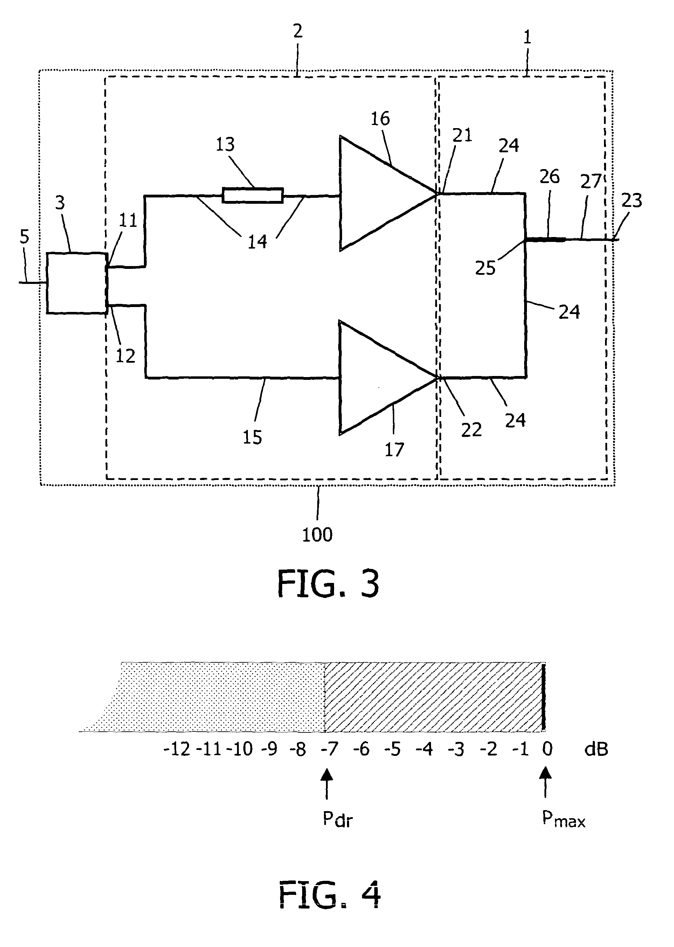

The adaptive RF amplifier will now be described with reference to Fig. 3. Like parts are indicated by the same numerals as in Fig. 1. In Fig. 3, the adaptive amplifier system is indicated as a whole at 100, comprising a combiner 1, an amplifier system 2 and an active signal splitter 3. In this figure, numeral 5 indicates the input and numeral 23 indicates the output of the amplifier system. The input signal is amplified in the active signal splitter 3 and split into two separate signals, which are taken off via splitter outputs 11 and 12. The signal splitter 3 may be an analog or a digital splitter. In the latter case, the signal on the input 5 might be digitally encoded; with the splitter 3 comprising D/A converters for converting the two split digital signals into analog signals on the outputs 11 and 12. Signal conductors 14 and 15 carry the split signals to amplifiers 16 and 17, respectively, in which signal conductor 14 a delay circuit 13 is incorporated. The outputs of the amplifiers 16 and 17 are connected to the inputs 21 and 22 of the combiner 1.

The behavior of the active signal splitter 3 is dependent on the amplitude of the input signal. In the case of a maximum signal size at the input 5, the output power at the output 23 likewise has a maximum value Pₘₐₓ. In the case of small signal sizes, below a certain threshold value corresponding to an output power P_{dr} of about -7 dB Pₘₐₓ, or 20% of the maximum output power, the split signals are amplified with a fixed amplification factor by the signal splitter 3, whilst a constant mutual phase difference of about 60 - 80 degrees is generated between the two split signals. The selection of the precise value of this phase difference is dependent on the optimum adaptation to the transistors that are used in the amplifiers 16 and 17. When the signal size at the input rises to a value above the threshold value, the phase difference between the two split signals will decrease continuously until the phase difference has decreased to 0 degrees with a maximum signal size. In the case of a maximum phase difference, the average face of the two split signals approximately equals zero. In the case of a decreasing phase difference between the two signals, the average phase can remain approximately zero or be given a value slightly different from zero so as to offset a possible phase shift in the amplifiers 16 and 17. Furthermore, the amplification factor of the signal splitter 3 has increased by a factor of 4 over this range, dependent on the output transistors that are used in the amplifiers 16 and 17. The desired output power of the transmitter is generated by the amplifiers 16 and 17 generate, which are so dimensioned that the signal splitter 3 will operate with a small signal size and that the power consumption of the signal splitter 3 will not influence the efficiency of the total system to an appreciable extent.

The operation of the adaptive amplifier system will now be explained with reference to Fig. 4. First, the situation in the case of maximum signal sizes will be described. In the case of maximum signal sizes, the phase difference between the split signals is 0 degrees. The output transistors are driven to full output and the combiner has a characteristic input impedance equal to the nominal impedance of the amplifiers. This is a common design, which provides an optimum efficiency. Now the condition in the case of small signal sizes will be described. In the case of small signal sizes, from zero to the threshold value, the split signals exhibit a constant mutual phase difference of about 60 to 80 degrees. The combiner has a constant input impedance but, due to the asymmetrical design, said constant input impedance is a factor of about 5 higher than the nominal impedance of the amplifiers. As a result, the efficiency of the amplifiers 16 and 17 is significantly higher than that of a conventional amplifier system. Furthermore, the amplification factor of the output amplifiers 16 and 16 is a factor of about 4 higher than with nominal impedance. The result is that less control signal is needed, so that less power needs to be supplied by the pre-amplifiers of the amplifiers 16 and 17, so that they require less electric current, as a result of which an additional improvement of the overall efficiency is achieved. The system operates as a linear amplifier in this range, albeit with a significantly improved efficiency. If the signal sizes increase to a value above the threshold value, the phase difference between the split signals, or the phase angle, decreases and the input impedance of the combiner decreases, and thus also the amplification factor of the output amplifiers 16 and 17. In the case of signal sizes from the threshold value to the maximum signal size, the output transistors are driven to full output. Furthermore, the amplification factor of the splitter 5 increases with a factor of about 4 for signal sizes from the threshold value to the maximum signal size so as to offset the decrease in the amplification factor of the output amplifiers 16 and 17 resulting from the lower terminal impedance (= input impedance of the combiner). The result is that the system functions as an LINC (Linear amplification using Non-linear Components) system for output signals above the threshold value, in which the amplifiers are driven to full output at all times, therefore, so that a higher efficiency level is achieved also with these input signals, compared to conventional amplifiers. In practice there will be a transition range between the range of linear operation and the range of full output in many cases. In said transition range, the phase angle between the two split signals already decreases, but the output amplifiers 16 and 17 are not driven to full output yet.

At maximum power, the efficiency of the amplifier system according to the present invention equals the efficiency of a conventional amplifier. At lower generated power levels, this high efficiency level is in principle maintained up to the threshold value of about 20% of maximum power, whereas the efficiency level of conventional amplifiers will already have decreased to less than half at that stage. At power levels that are even lower, lower than the threshold value, the efficiency level of the amplifier system of the present invention remains a constant factor higher than that of a conventional amplifier.

To achieve a variation in the terminal impedance of a factor of 4 to 5, the splitter must be able to generate a variation in the phase difference between the two split signals of 0 - 80 degrees. Some transistors no longer function optimally with a terminal impedance that is a factor of 4 to 5 higher than the nominal terminal impedance of the amplifier, however. In such cases it may be decided to use a lower a maximum phase difference from the splitter, so that the variation in the terminal impedance will also be less large.

In the example as described above, the signal conductors of the combiner are microstrip lines. It will be understood that the invention is not limited to this embodiment. Thus it is possible to select strip lines or coax lines. In an alternative embodiment, the signal conductor comprises one or more passive components, such as a capacitor. A capacitor is not an electrical conductor, to be true, but it is capable of passing an RF signal at the high frequencies that are usual in the RF applications.

## Claims

1. An amplifier system with a first and a second amplifier, comprising
a first input (11), which is connected to an input of a first amplifier (16) by means of a first amplifier signal conductor (14),
a second input (12), which is connected to an input of a second amplifier (17) by means of a second amplifier signal conductor (15), and
a combiner (1) for combining two signals, with two combiner inputs (21, 22) and a output (23), wherein outputs of the first and second amplifiers (16, 17) are connected to the inputs (21, 22) of the combiner (1) for combining the two amplified signals, and a first signal conductor (24), having a characteristic impedance, which interconnects the two combiner inputs (21, 22) to each other, wherein the path length of said first signal conductor (24) is approximately a whole number of a half wavelength of the signals that are to be combined at the design frequency of the combiner (1), and with a second signal conductor (27), having a characteristic impedance, connecting an outcoupling point (25) on the first signal conductor (24) to said combiner output (23), wherein the output (23) of the combiner (1) is also the output of the amplifier system, and wherein the outcoupling point (25) is asymmetrically positioned at unequal distance from the two combiner inputs (21, 22), wherein
a delay circuit (13) is incorporated in one of the amplifier signal conductors (14, 15), wherein the asymmetry of the outcoupling point (25) of the combiner (1) and the size of the delay circuit (13) are selected so that the phase shifts they introduce are of identical magnitude and opposite sense, so that said phase shifts offset each other at the outcoupling point (25), **characterized in that** the magnitude of the phase shift caused by the asymmetry of the combiner (1) is 25 to 45 degrees.

2. The amplifier system as claimed in claim 1, **characterized in that** the magnitude of the phase shift caused by the asymmetry of the combiner (1) is 30 to 40 degrees.

3. The amplifier system as claimed in claim in 1 or 2, **characterized in that** the combiner (1) has a resistor less output (23).

4. The amplifier system as claimed in one of the claims 1 to 3, **characterized in that** the signal conductors (14, 15, 24, 27) are configured as a microstrip line or as a stripline.

5. The amplifier system as claimed in one of the claims 1 to 4, **characterized in that** the second signal conductor (27) connects the outcoupling point (25) with the output (23) via a third signal conductor (26) having a characteristic impedance, wherein the second signal conductor (27) has a length amounting to about ¼ wavelength and a characteristic impedance that is the root of the product of the characteristic impedance of the first signal conductor (24), divided by two, and the characteristic impedance of the third signal conductor (26).

6. The amplifier system as claimed in one of the claims 1 to 5, **characterized in that** said signal conductors (14, 15, 24, 26, 27) are coax lines.

7. The amplifier system as claimed in one of the claims 1 to 6, **characterized in that** the two amplifiers (16, 17) have the same nominal output impedance, wherein the characteristic input impedance of the combiner (1) equals the nominal output impedance of the amplifiers (16, 17)

8. An adaptive amplifier system for amplifying RF signals, comprising an active signal splitter (3) at the input (5) of the system, which functions to amplify and split an input signal into two amplified and split signals, said splitter (3) comprising one splitter input (5) and two splitter outputs (11, 12), wherein the input of the system is connected or coincides with the input (5) of the splitter (3), and wherein the manner in which the splitter (3) amplifies and splits the input signal is dependent on the size of the input signal, **characterized in that** the outputs of the splitter (3) are connected to the inputs (11, 12) of the amplifier system as claimed in one of the claims 1 to 7.

9. The adaptive amplifier system as claimed in claim 8, **characterized in that** the splitter (3) effects a constant phase shift between the split signals and the signals amplified with a constant amplification factor in the case of input signals below a threshold value, whereas at the phase shift between the split signals decreases continuously to a value of about zero and the amplification factor increases continuously in the case of signals from the threshold value to a maximum value, so that the system behaves as a conventional linear amplifier with enhanced efficiency in the case of small signal sizes and as conventional LINC (Linear amplification using Non-linear Components) amplifier in the case of large signal sizes, with the output transistors being driven to full output all times.

10. The adaptive amplifier system as claimed in claim 8 or 9, **characterized in that** the splitter (3) effects a phase difference between the split signals of 60 to 80 degrees in the case of small input signals.

11. The adaptive amplifier system as claimed in one of the claims 8 to 10, **characterized in that** the amplification factor of the splitter (3) is about four times larger in the case of a maximal signal size that in the case of a small signal size.

12. The adaptive amplifier system as claimed in one of the claims 8 to 11, **characterized in that** the splitter (3) is an analogue circuit.

13. The adaptive amplifier system as claimed in one of the claims 8 to 11, **characterized in that** the splitter (3) is a digital splitter.

14. Use of the amplifier system as claimed in one of the claims 1 to 13 for amplifying one or more RF signals.

## Patentansprüche

1. Verstärkersystem mit einem ersten und einem zweiten Verstärker, umfassend:
einen ersten Eingang (11), der mit einem Eingang eines ersten Verstärkers (16) mittels eines ersten Verstärkersignalleiters (14) verbunden ist,
einen zweiten Eingang (12), der mit einem Eingang eines zweiten Verstärkers (17) mittels eines zweiten Verstärkersignalleiters (15) verbunden ist, und
einen Kombinator (1) zum Kombinieren von zwei Signalen, mit zwei Kombinatoreingängen (21, 22) und einem Kombinatorausgang (23), wobei die Ausgänge der ersten und zweiten Verstärker (16, 17) mit den Eingängen (21, 22) des Kombinators (1) verbunden sind, um die zwei verstärkten Signale zu kombinieren, und mit einem ersten Signalleiter (24), der eine charakteristische Impedanz aufweist und die zwei Kombinatoreingänge (21, 22) miteinander verbindet, wobei die Pfadlänge des ersten Signalleiters (24) ungefähr ein ganzzahliges Vielfaches einer halben Wellenlänge der Signale ist, die bei der Entwurfsfrequenz des Kombinators (1) zu kombinieren sind, und mit einem zweiten Signalleiter (27), der eine charakteristische Impedanz aufweist und einen Auskopplungspunkt (25) des ersten Signalleiters (24) mit dem Kombinatorausgang (23) verbindet, wobei der Ausgang (23) des Kombinators (1) auch der Ausgang des Verstärkersystems ist, und wobei der Auskopplungspunkt (25) in einem ungleichmäßigen Abstand von den zwei Kombinatoreingängen (21, 22) asymmetrisch angeordnet ist, wobei
eine Verzögerungsschaltung (13) in einem der Verstärkersignalleiter (14, 15) eingebaut ist, wobei die Asymmetrie des Auskopplungspunktes (25) des Kombinators (1) und das Maß der Verzögerungsschaltung (13) so gewählt sind, dass die Phasenverschiebungen, die diese einbringen, eine identische Größe und entgegengesetzte Richtung aufweisen, so dass die Phasenverschiebungen am Auskopplungspunkt (25) einander aufheben, **dadurch gekennzeichnet,**
**dass** die Größe der Phasenverschiebung, die durch die Asymmetrie des Kombinators (1) hervorgerufen wird, gleich 25 bis 45 Grad ist.

2. Verstärkersystem nach Anspruch 1, **dadurch gekennzeichnet, dass** die Größe der Phasenverschiebung, die durch die Asymmetrie des Kombinators (1) hervorgerufen wird, gleich 30 bis 40 Grad ist.

3. Verstärkersystem nach Anspruch 1 oder 2, **dadurch gekennzeichnet, dass** der Kombinator (1) einen widerstandslosen Ausgang (23) aufweist.

4. Verstärkersystem nach irgendeinem der Ansprüche 1 bis 3, **dadurch gekennzeichnet, dass** die Signalleiter (14, 15, 24, 27) als Mikrostreifenleitung oder als Streifenleitung konfiguriert sind.

5. Verstärkersystem nach irgendeinem der Ansprüche 1 bis 4, **dadurch gekennzeichnet, dass** der zweite Signalleiter (27) den Auskopplungspunkt (25) mit dem Ausgang (23) über einen dritten Signalleiter (26) mit einer charakteristischen Impedanz verbindet, wobei der zweite Signalleiter (27) eine Länge aufweist, die sich auf etwa 1/4 der Wellenlänge summiert, sowie eine charakteristische Impedanz, die gleich der Wurzel des Produkts aus der charakteristischen Impedanz des ersten Signalleiters (24) dividiert durch 2 und der charakteristischen Impedanz des dritten Signalleiters (26) ist.

6. Verstärkersystem nach irgendeinem der Ansprüche 1 bis 5, **dadurch gekennzeichnet, dass** die Signalleiter (14, 15, 24, 26, 27) Koaxialleitungen sind.

7. Verstärkersystem nach irgendeinem der Ansprüche 1 bis 6, **dadurch gekennzeichnet, dass** die zwei Verstärker (16, 17) die gleiche Nennausgangsimpedanz aufweisen, wobei die charakteristische Eingangsimpedanz des Kombinators (1) gleich der Nennausgangsimpedanz der Verstärker (16, 17) ist.

8. Adaptives Verstärkersystem zum Verstärken von HF-Signalen, das einen aktiven Signalverteiler (3) am Eingang (5) des Systems aufweist, der dazu dient, ein Eingangssignal zu verstärken und in zwei verstärkte und aufgeteilte Signale zu verteilen, wobei der Verteiler (3) einen Verteilereingang (5) und zwei Verteilerausgänge (11, 12) umfasst, wobei der Eingang des Systems mit dem Eingang (5) des Verteilers (3) verbunden ist oder zusammenfällt, und wobei die Art, in der der Verteiler (3) das Eingangssignal verstärkt und verteilt, von der Größe des Eingangssignals abhängt, **dadurch gekennzeichnet, dass** die Ausgänge des Verteilers (3) mit den Eingängen (11, 12) eines Verstärkersystems nach irgendeinem der Ansprüche 1 bis 7 verbunden sind.

9. Adaptives Verstärkersystem nach Anspruch 8, **dadurch gekennzeichnet, dass** der Verteiler (3) im Fall von Eingangssignalen unterhalb eines Schwellenwertes eine konstante Phasenverschiebung zwischen den verteilten Signalen und den mit einem konstanten Verstärkungsfaktor verstärkten Signalen bewirkt, während im Fall von Signalen vom Schwellenwert bis zu einem Maximalwert die Phasenverschiebung zwischen den verteilten Signalen kontinuierlich auf einen Wert von etwa gleich 0 abnimmt und der Verstärkungsfaktor kontinuierlich zunimmt, so dass sich das System im Fall kleiner Signalgrößen wie ein herkömmlicher linearer Verstärker mit einer gesteigerten Effizienz, und im Fall großer Signalgrößen wie ein herkömmlicher LINC-Verstärker (lineare Verstärkung unter Verwendung nichtlinearer Komponenten) verhält, wobei die Ausgangstransistoren ständig auf volle Ausgangsleistung gesteuert werden.

10. Adaptives Verstärkersystem nach Anspruch 8 oder 9, **dadurch gekennzeichnet, dass** der Verteiler (3) im Fall kleiner Eingangssignale eine Phasendifferenz zwischen den verteilten Signalen von 60 bis 80 Grad bewirkt.

11. Adaptives Verstärkersystem nach irgendeinem der Ansprüche 8 bis 10, **dadurch gekennzeichnet, dass** der Verstärkungsfaktor des Verteilers (3) im Fall einer maximalen Signalgröße etwa vier mal größer ist als im Fall einer kleinen Signalgröße.

12. Adaptives Verstärkersystem nach irgendeinem der Ansprüche 8 bis 11, **dadurch gekennzeichnet, dass** der Verteiler (3) eine analoge Schaltung ist.

13. Adaptives Verstärkersystem nach irgendeinem der Ansprüche 8 bis 11, **dadurch gekennzeichnet, dass** der Verteiler (3) ein digitaler Verteiler ist.

14. Verwendung des Verstärkersystem nach irgendeinem der Ansprüche 1 bis 13 zum Verstärken eines oder mehrerer HF-Signale.

## Revendications

1. Système d'amplificateurs doté d'un premier et d'un second amplificateurs, comprenant :
une première entrée (11), laquelle est connectée à une entrée d'un premier amplificateur (16) au moyen d'un premier conducteur de signaux d'amplificateur (14),
une seconde entrée (12), laquelle est connectée à une entrée d'un second amplificateur (17) au moyen d'un second conducteur de signaux d'amplificateur (15), et
un combinateur (1) permettant de combiner deux signaux doté de deux entrées de combinateur (21, 22) et d'une sortie de combinateur (23), dans lequel des sorties des premier et second amplificateurs (16, 17) sont connectées aux entrées (21, 22) du combinateur (1) pour combiner les deux signaux amplifiés, et un premier conducteur de signaux (24), ayant une impédance caractéristique, qui interconnecte les deux entrées de combinateur (21, 22) l'une à l'autre, dans lequel la longueur de parcours dudit premier conducteur de signaux (24) représente approximativement un nombre entier de demi longueur d'onde des signaux qui doivent être combinés à la fréquence de conception du combinateur (1), et avec un second conducteur de signaux (27), présentant une impédance caractéristique, connectant un point de couplage de sortie (25) sur le premier conducteur de signaux (24) à ladite sortie de combinateur (23),
dans lequel la sortie (23) du combinateur (1) représente également la sortie du système d'amplificateurs, et
dans lequel le point de couplage de sortie (25) est positionné de façon asymétrique à une distance inégale des deux entrées de combinateur (21, 22), dans lequel une ligne à retard (13) est incorporée dans l'un des conducteurs de signaux d'amplificateur (14, 15), dans lequel l'asymétrie du point de couplage de sortie (25) du combinateur (1) et la taille de la ligne à retard (13) sont sélectionnées de façon que lesdits décalages de phase qu'ils introduisent soient d'amplitude identique et de sens opposé de sorte que lesdits déphasages se compensent l'un l'autre, **caractérisé en ce que**
l'amplitude du décalage de phase entraînée par l'asymétrie du combinateur soit de 25 à 45 degrés.

2. Système d'amplificateurs selon la revendication 1, **caractérisé en ce que** l'amplitude du décalage de phase entraînée par l'asymétrie du combinateur (1) est de 30 à 40 degrés.

3. Système d'amplificateurs selon la revendication 1 ou 2, **caractérisé en ce que** le combinateur (1) possède une sortie de moindre résistance (23).

4. Système d'amplificateurs selon l'une quelconque des revendications 1 à 3, **caractérisé en ce que** les conducteurs de signaux (14, 15, 24, 27) sont configurés sous la forme d'une ligne microruban ou d'une ligne à ruban équilibré.

5. Système d'amplificateurs selon l'une des revendications 1 à 4, **caractérisé en ce que** le second conducteur de signaux (27) connecte le point de couplage de sortie (25) avec la sortie (23) par l'intermédiaire d'un troisième conducteur de signaux (26) présentant une impédance caractéristique, dans lequel le second conducteur de signaux (27) a une longueur s'élevant à environ un quart de longueur d'onde et une impédance caractéristique qui est la racine du produit de l'impédance caractéristique du premier conducteur de signaux (24), divisée par deux, et de l'impédance caractéristique du troisième conducteur de signaux (26).

6. Système d'amplificateurs selon l'une des revendications 1 à 5, **caractérisé en ce que** lesdits conducteurs de signaux (14, 15, 24, 26, 27) sont des lignes coaxiales.

7. Système d'amplificateurs selon l'une des revendications 1 à 6, **caractérisé en ce que** les deux amplificateurs (16, 17) présentent la même impédance nominale de sortie, dans lequel l'impédance d'entrée caractéristique du combinateur (1) est égale à l'impédance nominale de sortie des amplificateurs (16, 17) .

8. Système d'amplificateurs adaptatif pour amplifier des signaux RF, comportant un diviseur de signaux actif (3) au niveau de l'entrée (5) du système, lequel opère en vue d'amplifier et de diviser un signal d'entrée en deux signaux séparés et amplifiés, ledit diviseur (3) comprenant une entrée de diviseur (5) et deux sorties de diviseur (11, 12), dans lequel l'entrée du système est connectée ou coïncide avec l'entrée (5) du diviseur (3), et dans lequel la manière suivant laquelle le diviseur (3) amplifie et divise le signal d'entrée dépend de la dimension du signal d'entrée, **caractérisé en ce que** les sorties du diviseur (3) sont connectées aux entrées (11, 12) du système d'amplificateurs tel que revendiqué selon l'une des revendications 1 à 7.

9. Système d'amplificateurs adaptatif selon la revendication 8, **caractérisé en ce que** le diviseur (3) effectue un décalage de phase constant entre les signaux séparés et les signaux amplifiés avec un facteur d'amplification constant dans le cas des signaux d'entrée au-dessous d'une valeur de seuil, tandis que le décalage de phase entre les signaux divisés diminue de façon continue vers une valeur pratiquement nulle et que le facteur d'amplification augmente de façon continue dans le cas de signaux allant de la valeur de seuil à une valeur maximale, de sorte que le système se comporte comme un amplificateur linéaire conventionnel ayant une efficacité accrue dans le cas des faibles dimensions de signaux et comme un amplificateur LINC (Amplification linéaire utilisant des composants non linéaires) conventionnel dans le cas de grandes dimensions du signal, les transistors de sortie étant commandés pour une sortie toujours à saturation .

10. Système d'amplificateurs adaptatif selon la revendication 8 ou 9, **caractérisé en ce que** le diviseur (3) effectue une différence de phase entre les signaux séparés de 60 à 80 degrés dans le cas de petits signaux d'entrée.

11. Système d'amplificateurs adaptatif selon l'une des revendications 8 à 10, **caractérisé en ce que** le facteur d'amplification du diviseur (3) est quatre fois plus grand environ dans le cas d'une dimension maximale de signal que dans le cas d'une petite dimension de signal.

12. Système d'amplificateurs adaptatif selon l'une des revendications 8 à 11, **caractérisé en ce que** le diviseur (3) est un circuit analogique.

13. Système d'amplificateurs adaptatif selon l'une des revendications 8 à 11, **caractérisé en ce que** le diviseur (3) est un diviseur numérique.

14. Utilisation du système d'amplificateurs selon l'une quelconque des revendications 1 à 13 pour amplifier un ou plusieurs signaux (signaux) RF.
